(19) **Europäisches Patentamt**

**European Patent Office**

**Office européen des brevets**

(11) **EP 1 158 291 B1**

(12) **FASCICULE DE BREVET EUROPEEN**

(45) Date de publication et mention
de la délivrance du brevet:
**07.04.2004  Bulletin 2004/15**

(51) Int Cl.⁷: **G01N 21/21**, G01N 21/95,
G01B 11/06

(21) Numéro de dépôt: **01401283.5**

(22) Date de dépôt: **17.05.2001**

(54) **Procédé et appareil de métrologie ellipsométrique pour échantillon contenu dans une chambre ou analogue**

Ellipsometrisches Messverfahren und entsprechende Vorrichtung für in einer Kammer oder dergleichen enthaltene Proben

Ellipsometric metrology method and apparatus for samples contained in a chamber or the like

(84) Etats contractants désignés:
**AT BE CH CY DE DK ES FI FR GB GR IE IT LI LU MC NL PT SE TR**

(30) Priorité: **26.05.2000  FR 0006771**

(43) Date de publication de la demande:
**28.11.2001  Bulletin 2001/48**

(73) Titulaire: **Société de Production et de Recherches Appliquées**
**92270 Bois-Colombes (FR)**

(72) Inventeurs:
 • **Stehle, Jean-Louis**
 **92700 Colombes (FR)**

 • **Boher, Pierre**
 **91330 Yerres (FR)**

(74) Mandataire: **Plaçais, Jean-Yves et al**
 **Cabinet Netter,**
 **36, avenue Hoche**
 **75008 Paris (FR)**

(56) Documents cités:
 **DE-A- 19 717 885**  **DE-A- 19 723 729**
 **US-A- 4 198 261**  **US-A- 4 676 644**
 **US-A- 5 354 575**  **US-A- 5 764 365**

**Description**

La présente invention concerne la métrologie ellipsométrique pour échantillon contenu dans une chambre ou analogue, afin d'obtenir des mesures non destructives relatives à l'état de surface dudit échantillon, sans sortir l'échantillon de la chambre.

Elle trouve une application générale dans la caractérisation optique d'un échantillon, et plus particulièrement d'un échantillon en couches minces semi-conductrices. Elle trouve ainsi une application dans le suivi de la production de circuits intégrés.

Généralement, l'ellipsométrie est utilisée pour mesurer en temps réel et in-situ un changement de surface au cours d'un procédé de fabrication de circuits intégrés, par exemple lors de la croissance de couches sur un substrat.

Différentes solutions connues ont été décrites dans US 4,198,261, US 5,354,575 et US 5,402,237.

De manière connue, un appareil d'ellipsométrie achemine un faisceau d'illumination polarisé sur l'échantillon selon un angle d'incidence oblique prédéterminé par rapport à la surface de l'échantillon. Le faisceau d'illumination est réfléchi par l'échantillon de façon symétrique par rapport à une normale à la surface de l'échantillon. Le faisceau de réflexion résultant de l'illumination de l'échantillon est ensuite acheminé sur un dispositif analyseur de polarisation dont le faisceau de sortie est détecté pour être traité. Les changements de l'état de polarisation en phase et en amplitude causés par la réflexion sur l'échantillon sont traités afin d'en déduire des paramètres physiques représentatifs de l'échantillon.

En pratique, la fabrication de circuits intégrés comprend plusieurs étapes d'élaboration dont certaines comprennent le dépôt de plusieurs couches successives. Le plus souvent, le dépôt de ces couches doit être réalisé sans sortir l'échantillon de la chambre de dépôt, notamment pour éviter de rompre l'atmosphère contrôlé de la chambre ou de polluer l'échantillon.

Or, il est souvent nécessaire de mesurer des paramètres physiques d'une couche avant le dépôt ou l'élaboration de la couche suivante.

Une solution connue consiste à mesurer en temps réel et in-situ la croissance des couches (ou la gravure) à l'aide d'un appareil de métrologie ellipsométrique.

Une telle solution a l'inconvénient d'exiger autant d'appareils de métrologie ellipsométrique que de chambres de dépôt ou d'élaboration, ce qui la rend relativement onéreuse.

De plus, dans certaines étapes d'élaboration des couches (étape de métallisation par exemple), il est difficile ou impossible du fait dé l'absorption optique des couches, de mettre en oeuvre une telle solution ellipsométrique.

Enfin, il est pratiquement impossible de mener à bien une cartographie de l'échantillon sans sortir l'échantillon de la chambre et/ou sans déplacer l'échantillon relativement au faisceau d'illumination, ce qui est parfois difficile à mettre en oeuvre dans une chambre en raison des dimensions limitées de la chambre ou en raison de la difficulté d'intégrer à l'intérieur de la chambre un porte-échantillon mobile en X, Y et/ou Z.

La présente invention remédie à ces inconvénients.

Elle a ainsi pour principal objectif d'intégrer une métrologie ellipsométrique dans une chambre, sans sortir l'échantillon de ladite chambre, afin de mesurer l'échantillon, par exemple entre deux procédés d'élaboration ou à la fin de l'un de ces derniers, sans polluer les circuits intégrés en cours de fabrication et/ou sans rompre l'atmosphère contrôlée de la chambre.

A cet effet, la présente invention porte sur un procédé de métrologie ellipsométrique pour un échantillon contenu dans une chambre.

Selon une caractéristique importante de l'invention, le procédé comprend les étapes suivantes enoncées dans la revendication 1.

Le procédé selon l'invention permet ainsi d'effectuer une mesure d'ellipsométrie sur l'échantillon sans le sortir de la chambre, ce qui évite tout problème de pollution, notamment lors de la fabrication des circuits intégrés. Le procédé selon l'invention a aussi l'avantage de ne pas rompre l'atmosphère contrôlée de la chambre. De plus, la fenêtre permet à un opérateur, le cas échéant à l'aide d'un microscope, de positionner précisément le faisceau d'illumination sur l'échantillon.

La présente invention vise en outre une métrologie ellipsométrique permettant de réaliser une cartographie de l'échantillon sans sortir ledit échantillon de la chambre et sans déplacer l'échantillon.

A cet effet, le procédé selon l'invention comprend en outre une étape j) qui consiste à maintenir l'échantillon fixe dans la chambre, et à déplacer longitudinalement et/ou latéralement le faisceau d'illumination polarisé pour illuminer une autre zone de l'échantillon, et à répéter les étapes d) à i), selon le même angle d'incidence oblique.

L'étape j) permet ainsi d'effectuer une pluralité de mesures d'ellipsométrie sur une pluralité de zones de l'échantillon sans déplacer ledit échantillon et sans sortir l'échantillon hors de la chambre. On obtient donc une cartographie de l'échantillon sans difficulté de mise en oeuvre, sans engendrer de pollution et sans rompre l'atmosphère contrôlée de la chambre.

Avantageusement, l'étape j) consiste en outre à déplacer transversalement le faisceau d'illumination sur l'échantillon fixe, à travers la fenêtre, afin d'ajuster la distance entre l'appareil de métrologie et la surface de l'échantillon.

De préférence, le procédé comprend en outre une étape de calibration dans laquelle on effectue les étapes suivantes:

1) effectuer au moins une première mesure ellipsométrique sur un échantillon prédéterminé, selon des premières conditions expérimentales, sans fenêtre,

2) effectuer au moins une seconde mesure ellipsométrique sur le même échantillon que celui de l'étape 1), selon des secondes conditions expérimentales généralement semblables aux premières conditions expérimentales, mais à travers la fenêtre,

3) déterminer à partir des première et seconde mesures ellipsométriques, l'effet résultant de la fenêtre sur le rapport des amplitudes tangente $\psi$ des polarisations perpendiculaires et parallèles du faisceau de réflexion pour en déduire un facteur de correction ; et

4) tenir compte dans le traitement, du facteur de correction ainsi déduit.

La présente invention a également pour objet un appareil de métrologie ellipsométrique pour la mise en oeuvre du procédé selon l'invention.

La présente invention utilise une chambre formant boîte propre à contenir un échantillon et comprenant une interface avec une fenêtre de dimensions et caractéristiques choisies, disposée dans un plan sensiblement parallèle à la surface de l'échantillon et fermant au moins partiellement la boîte, la boîte étant destinée à être associée à un appareil de métrologie tel que visé ci-avant.

D'autres caractéristiques et avantages de l'invention apparaîtront à la lumière de la description détaillée ci-après et des dessins dans lesquels :

- la figure 1 est une vue schématique d'une installation de fabrication de circuits intégrés équipée de plusieurs chambres de dépôt de couches selon l'art antérieur;

- la figure 2 est une vue schématique d'un appareil de métrologie ellipsométrique selon l'invention intégré à une chambre de refroidissement de l'installation de la figure 1;

- la figure 3 est une autre vue schématique de l'appareil de métrologie ellipsométrique selon l'invention;

- la figure 4 représente schématiquement les éléments essentiels de l'appareil de métrologie ellipsométrique selon l'invention;

- la figure 5 illustre schématiquement le trajet optique du faisceau d'illumination à travers une fenêtre fermant au moins partiellement une chambre selon l'invention;

- la figure 6 représente une courbe du paramètre tangente psi, mesuré en ligne droite à travers une fenêtre inclinée à 58° en fonction de la longueur d'onde;

- la figure 7 représente des courbes de mesure du paramètre tangente psi sur un substrat de silicium avec ou sans fenêtre en fonction de la longueur d'onde;

- la figure 8 représente une courbe du facteur de correction résultant de l'effet de la fenêtre à appliquer au paramètre tangente psi mesuré en fonction de la longueur d'onde;

- la figure 9 représente une courbe de l'épaisseur de silice mesurée sur un substrat de silicium avec ou sans fenêtre sur un grand diamètre de l'échantillon; et

- la figure 10 représente schématiquement une boîte formant chambre contenant un échantillon et propre à s'adapter sur l'appareil de métrologie selon l'invention.

Les dessins comportent des éléments de caractère certain. A ce titre, ils peuvent non seulement servir à mieux comprendre l'invention, mais aussi le cas échéant à la définition de celle-ci.

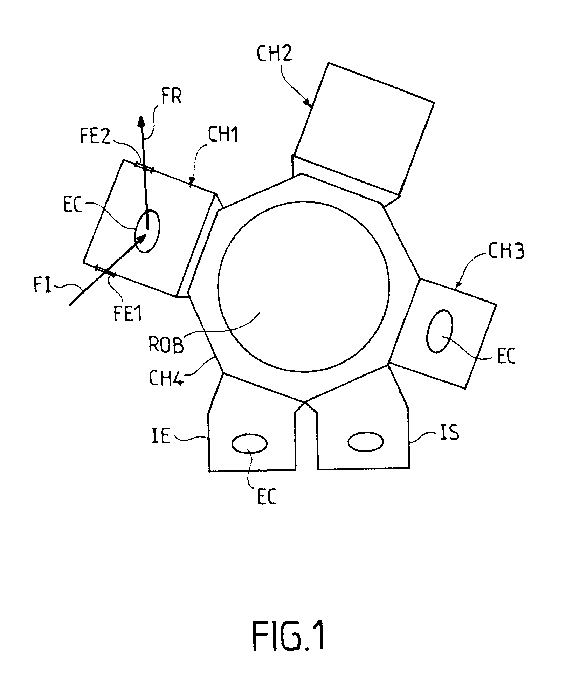

En référence à la figure 1, on a représenté une installation de fabrication de circuits intégrés de l'art antérieur.

L'installation comprend plusieurs chambres CH, individualisées en CH1 à CH3, disposées en étoile autour d'une chambre de transfert CH4. A l'intérieur de la chambre CH4, un automate ROB est capable d'introduire ou extraire au moins un échantillon EC d'une chambre CH à une autre. Les échantillons EC proviennent d'une interface d'entrée IE et sont acheminés après traitement vers une interface de sortie IS.

Les chambres CH1 et CH2 sont par exemple des chambres de dépôt de couche par épitaxie. La chambre CH3 est par exemple une chambre de refroidissement.

En pratique, l'atmosphère dans les chambres est contrôlée par des équipements bien connus de l'homme de l'art.

Par exemple, la chambre CH1 est équipé d'un appareil de métrologie ellipsométrique de l'art antérieur, dont on a représenté seulement les faisceaux d'illumination FI et de réflexion FR sur un échantillon EC. Cet appareil est capable d'effectuer une mesure d'ellipsométrie pour mesurer en temps réel et in situ un changement de surface, par exemple au cours de la croissance de couche sur un substrat.

De façon connue, l'appareil d'ellipsométrie achemine un faisceau d'illumination polarisé FI sur l'échantillon EC selon un angle d'incidence oblique prédéterminée par rapport à la surface de l'échantillon. Le faisceau d'illumination FI est réfléchi par l'échantillon de façon symétrique par rapport à une normale à la surface de l'échantillon. Le faisceau de réflexion FR résultant de l'illumination de l'échantillon est ensuite acheminé sur un dispositif analyseur de polarisation dont le faisceau de sortie est détecté pour être traité. Les changements de l'état de polarisation en phase et en amplitude causés par la réflexion sur l'échantillon sont traités afin d'en déduire des paramètres physiques représentatifs de l'échantillon.

Des fenêtres F1 et F2 sont pratiquées dans la chambre CH1, sur des chemins optiques conduisant respectivement, le faisceau d'illumination FI vers la chambre CH1, et le faisceau de réflexion FR hors de la chambre CH1. Les fenêtres F1 et F2 sont disposées perpendiculairement au faisceau de mesure. L'angle d'incidence doit être de l'ordre de 60-75° par rapport à la normale de l'échantillon, ce qui impose des contraintes géométriques souvent incompatibles avec certains procédés de dépôt.

En référence à la figure 1, l'ellipsométrie s'effectue durant le procédé d'élaboration de couches (croissance ou gravure).

L'élaboration de ces couches doit généralement être réalisée sans sortir l'échantillon de la chambre de dépôt et aussi sans rompre l'atmosphère contrôlée de la chambre.

Or, il est souvent nécessaire de mesurer des paramètres physiques d'une couche avant le dépôt ou l'élaboration de la couche suivante.

La solution d'ellipsométrie telle que représentée en figure 1 a l'inconvénient d'exiger autant d'appareils de métrologie ellipsométrique que de chambres de dépôt ou d'élaboration. De plus, dans certaines étapes de l'élaboration des couches, notamment dans l'étape de métallisation, il est difficile de mettre en oeuvre une telle solution ellipsométrique in-situ. Enfin, pour mener à bien une cartographie de l'échantillon, il convient de déplacer l'échantillon relativement au faisceau d'illumination, ce qui est parfois difficile à mettre en oeuvre dans une chambre en raison des dimensions limitées de la chambre ou en raison de la difficulté d'intégrer à l'intérieur de la chambre un porte-échantillon mobile en X, Y et/ou Z.

C'est dans ce contexte, que la Demanderesse propose selon l'invention une solution permettant notamment d'effectuer des mesures ellipsométriques sur un échantillon sans sortir ledit échantillon de la chambre.

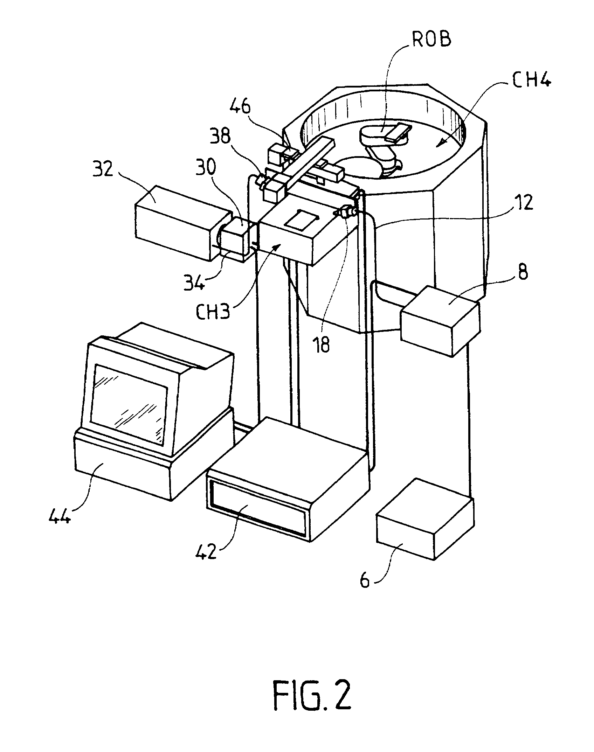

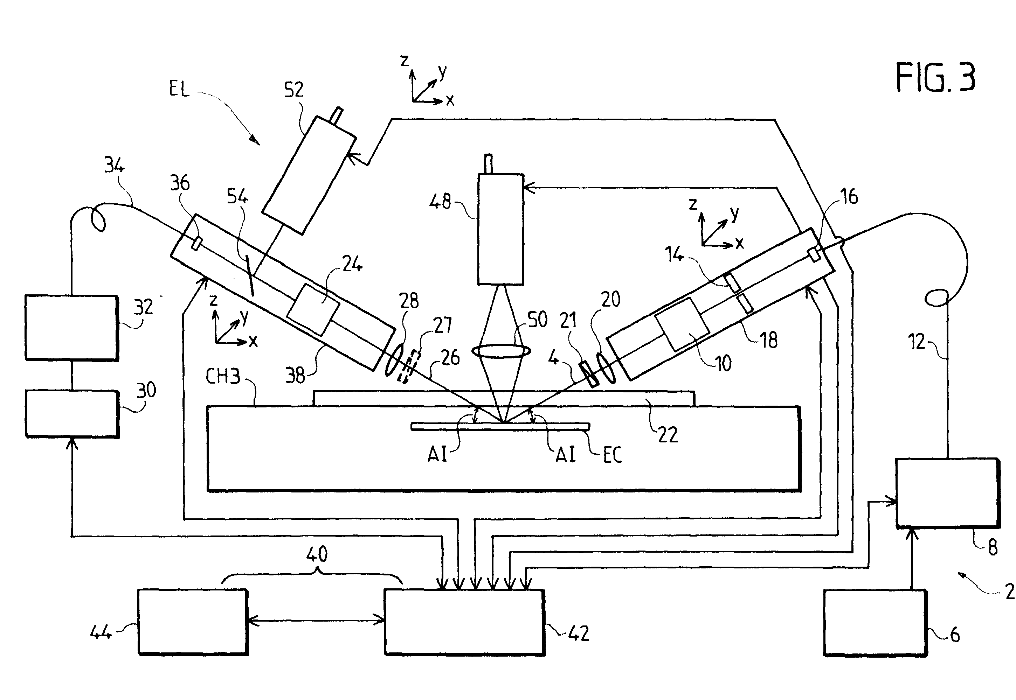

En référence aux figures 2 et 3, on retrouve les chambres CH3 et CH4 de l'installation de la figure 1, ainsi que l'automate de transfert ROB.

L'appareil de métrologie ellipsométrique EL selon l'invention comprend une source de lumière 2 disposée hors de la chambre CH3 pour produire un faisceau d'illumination 4. La source de lumière 2 comprend une alimentation 6 et une lampe 8, par exemple une lampe à arc au xénon dans le cas d'une ellipsométrie spectroscopique, ou bien une source laser dans le cas d'une ellipsométrie monochromatique.

Un dispositif polariseur 10 est disposé hors de la chambre CH3 pour polariser le faisceau d'illumination 2. Le dispositif polariseur 10 comprend un polariseur de type Rochon par exemple. Le polariseur 10 est relié à la lampe 8 par une fibre optique 12. Le dispositif polariseur 10 comprend un diaphragme 14 monté en amont du polariseur et en aval du coupleur d'entrée de fibre optique 16 selon le sens de la propagation de la lumière, afin de supprimer les polarisations parasites du polariseur. Les éléments 10, 14 et 16 sont avantageusement logés dans un bras 18 formant tête d'illumination.

Le faisceau d'illumination 2 peut être acheminé vers l'échantillon EC par des moyens de focalisation 20 de type objectif de microscope. L'échantillon EC est monté sur un porte-objet (non représenté), de préférence fixe.

La chambre CH3 est par exemple une chambre de refroidissement. Elle a une forme parallélépipédique. Elle est apte à contenir des échantillons de dimensions différentes, par exemple de diamètre de 200 millimètres.

La chambre CH3 est au moins partiellement fermée par une fenêtre 22 de dimensions et caractéristiques choisies, disposée dans un plan sensiblement parallèle à la surface de l'échantillon et fermant au moins partiellement la chambre.

Par exemple, la fenêtre 22 est en matériau PUROPSIL (Marque déposée), de type silice, isotropique et transparent dans l'Ultra-Violet.

Par exemple, les dimensions de la fenêtre sont de l'ordre de 130mm x 50mm x 4 mm.

L'objectif 20 achemine le faisceau d'illumination 4 polarisé sur une zone de l'échantillon, selon un premier chemin optique allant de la tête d'illumination 18 jusqu'à la zone de l'échantillon à travers la fenêtre 22.

Une lame compensatrice 21 peut éventuellement être interposée entre le polariseur 10 et la fenêtre 22 afin d'améliorer les conditions de mesure sur certains échantillons (notamment lorsque la variation de phase due à la réflexion sur l'échantillon est de l'ordre de +/- 90°).

Le premier chemin optique forme un angle d'incidence AI oblique prédéterminé par rapport à la surface de l'échantillon.

En pratique, l'angle d'incidence AI est de l'ordre de 58°.

Un dispositif analyseur 24 de polarisation est prévu hors de la chambre CH3.

Un faisceau de réflexion 26 résulte de l'illumination de l'échantillon par le faisceau d'illumination 4. Le faisceau de réflexion 26 est acheminé par un objectif 28 sur le dispositif analyseur 24 selon un second chemin optique allant de l'échantillon vers le dispositif analyseur à travers la fenêtre 22.

Le faisceau de réflexion 26 est symétrique du faisceau d'illumination 4 par rapport à une normale à la surface de l'échantillon.

Une lame compensatrice 27 peut être interposée entre la fenêtre 22 et l'analyseur 24, afin de jouer une fonction similaire à celle jouée par la lame 21 lorsque celle-ci est absente.

De même, cette fonction compensatrice peut être assurée par une couche d'un matériau approprié (non représenté) ou d'un dépôt multicouches revêtant la surface interne et/ou externe de la fenêtre. Les propriétés physiques de ce revêtement (indices optiques, épaisseurs) sont choisies de façon à induire une variation de phase due à la fenêtre de l'ordre de 90° dans les gammes spectrales utiles. Ce revêtement est bien évidemment transparent dans ces gammes spectrales (silice, nitrure, alumine).

Un dispositif de détection 30, de type photodétecteur par exemple, détecte le faisceau de sortie issu du dispositif analyseur 24 pour fournir un signal de sortie. En présence d'une source lumineuse 2 à large bande, le photodétecteur est précédé d'un monochromateur ou spectromètre 32. Une fibre optique 34 relie le monochromateur ou spectromètre 32 au dispositif analyseur 24, à l'aide d'un coupleur d'entrée 36. Les éléments 24, 36 sont avantageusement logés dans un bras 38 formant tête d'analyse.

Des moyens de traitement 40 traitent le signal de sortie pour déterminer les changements de l'état de polarisation en phase et en amplitude causés par la réflexion sur la zone de l'échantillon. Les moyens de traitement 40 comprennent une unité électronique de commande 42 et un micro-ordinateur 44.

Les bras d'illumination 18 et d'analyse 38 sont agencés pour réduire la taille de l'appareil de métrologie afin d'améliorer sa compacité.

Les bras d'illumination 18 et d'analyse 38 sont solidaires d'une table 46 mobile en X et en Y, dans un plan parallèle à la surface de l'échantillon.

Cette table est utilisée pour déplacer en X et en Y le faisceau d'illumination 4 sur la surface de l'échantillon. En pratique, le déplacement en X s'effectue sur une course de l'ordre de 100 millimètres et le déplacement en Y s'effectue sur une plus petite course, par exemple de l'ordre de 10 millimètres.

La table 46 est de préférence mobile en Z, pour adapter la distance entre les bras d'illumination et d'analyse et la surface de l'échantillon. Cette adaptation est utile dans le cas d'un spot d'illumination de dimensions faibles par rapport à la précision de déplacement de la table.

L'angle d'incidence AI est par exemple fixé à l'issue d'une étape de calibration autour de 58°.

Un dispositif de reconnaissance d'images 48, de type caméra CCD, comprenant une lentille 50, est également prévu pour prendre des images de l'échantillon, en angle droit relativement à la surface de l'échantillon. De préférence, ce dispositif 48 est solidaire de la table mobile.

De même, un dispositif d'autofocus 52, de type caméra CCD, intercepte à l'aide d'un séparateur 54, le signal issu de l'analyseur 24 afin d'adapter l'autofocus de l'appareil. De préférence, ce dispositif 52 est aussi solidaire de la table mobile.

L'unité électronique de commande 42 pilote notamment le déplacement en X, Y et Z de la table 46 pour déplacer les éléments 18, 38, 48 et 52. L'unité 42 commande également les éléments 8 et 30.

L'une des principales caractéristiques du dispositif de métrologie selon l'invention réside dans la fenêtre 22, plane, disposée dans un plan parallèle à celui de la surface de l'échantillon, et fermant au moins partiellement la chambre contenant l'échantillon, les bras d'illumination 18 et d'analyse 38 étant disposés hors de la chambre.

Lorsque les bras d'illumination 18 et d'analyse 38 sont disposés selon une configuration appelée "straight line", c'est-à-dire en ligne droite, les tests montrent que l'appareil de métrologie ellipsométrique fonctionne correctement lorsque le paramètre tangente psi ($\Psi$) est égal à 1 +/- 0,01 et lorsque le paramètre cosinus delta ($\Delta$) est égal à 1 +/-0,01 dans la plage de longueur d'onde 0,25 nm à 0,85 nm.

La Demanderesse a effectué des calculs pour déterminer l'effet de la fenêtre sur le calcul des paramètres ellipsométriques, notamment tangente psi et cosinus delta.

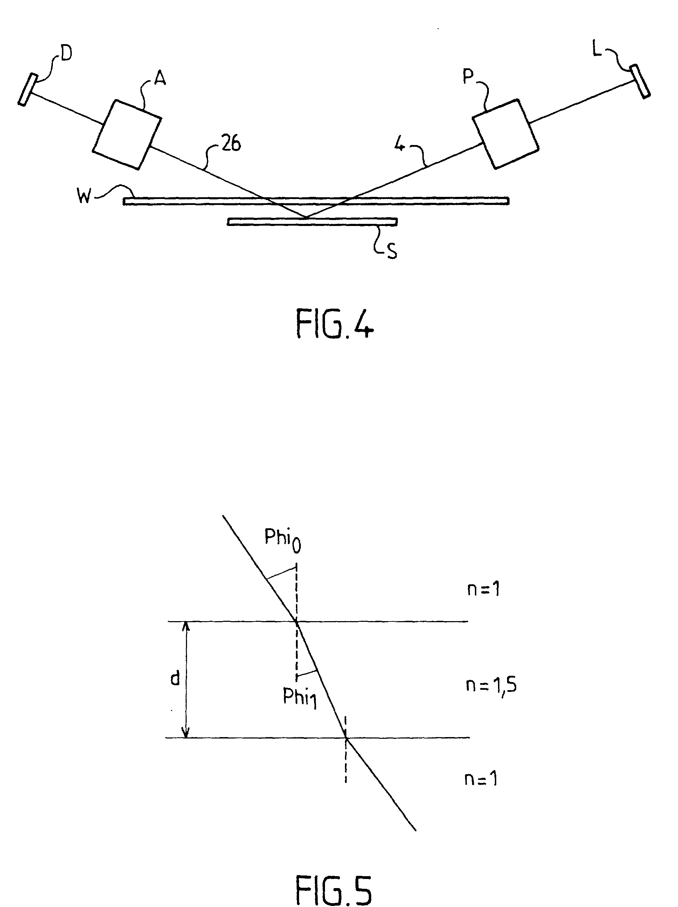

En référence à la figure 4, on retrouve les éléments essentiels de l'appareil qui participent au calcul, avec $E_L$ pour la source, P pour le polariseur, W pour la fenêtre, S, pour l'échantillon, A pour l'analyseur, et D pour le détecteur.

L'équation 1 en annexe donne le champ électrique $E_D$ sur le détecteur.

L'équation 2 en annexe exprime en matrice le champ électrique $E_D$ sur le détecteur.

L'équation 3 en annexe exprime l'intensité I sans la fenêtre. Les coefficients K, $\alpha$ et $\beta$ de l'équation 3 sont donnés respectivement dans les équations 4, 5, et 6 en annexe.

D'une manière générale, les paramètres tangente psi et cosinus delta sont exprimés respectivement selon les équations 7 et 8 en annexe.

Lorsque la fenêtre est placée entre l'échantillon et les bras d'illumination et d'analyse, le calcul matriciel est exprimé selon l'équation 9 en annexe, ce qui permet d'exprimer les paramètres tangente psi et cosinus delta avec ou sans fenêtre selon les équations 10 et 11 en annexe.

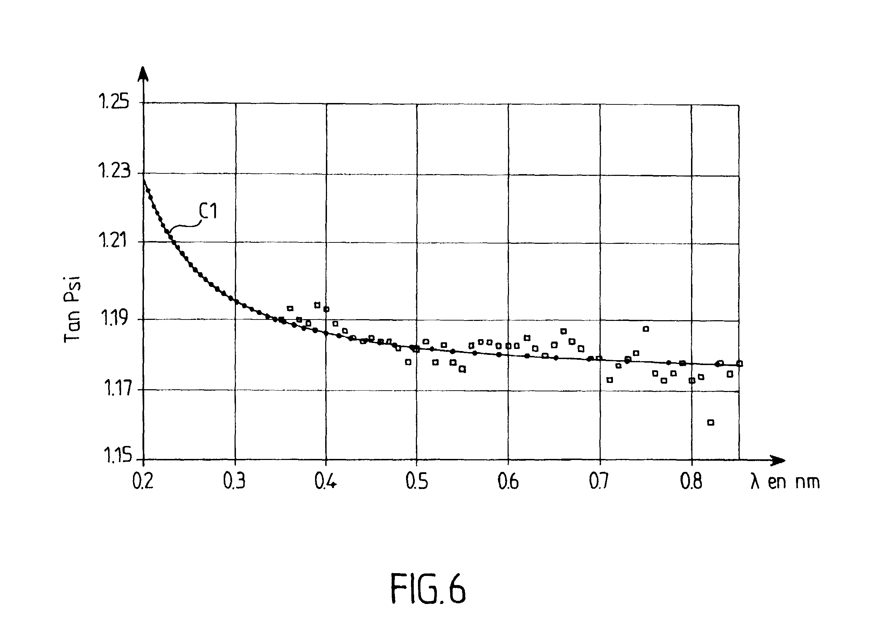

En référence à la figure 5, on a représenté le trajet optique du faisceau d'illumination ou de réflexion à travers une fenêtre. La Demanderesse a par exemple évalué l'effet d'une fenêtre du type PUROPSIL (marque déposée) d'une épaisseur d de 4 mm et de coefficient n (par exemple n = 1,5).

La transmittance T de la fenêtre est donnée dans l'équation 12 dans laquelle les coefficients $t_{01}$, $t_{10}$, $r_{01}$, et $r_{10}$ sont les coefficients de Fresnel correspondant aux coefficients de transmission et de réflexion au niveau de l'interface ambiant/fenêtre et fenêtre ambiant (équations 13, 14, 15, et 16). Le paramètre $\delta$ représente le décalage de phase due à l'épaisseur de la fenêtre (équation 17).

Le produit des coefficients $t_{01} * t_{10}$ est exprimé dans l'équation 18 en annexe.

Les deux coefficients a et b de la matrice exprimée dans l'équation 9 sont donnés respectivement dans les équations 19 et 20.

Le facteur de correction destiné à être appliqué au paramètre tangente psi est donné en référence à l'équation 21. L'équation 22 exprime le facteur de correction à appliquer au décalage de phase.

Il apparaît donc à l'issue des calculs théoriques (en ligne droite), que le paramètre tangente psi doit être corrigé d'un facteur choisi, sensiblement dépendant de la longueur d'onde (à travers la légère variation de l'indice de réfraction de la fenêtre en fonction de la longueur d'onde) tandis que le paramètre cosinus delta n'est pas affecté par la fenêtre.

En référence à la figure 6, on a représenté les valeurs ponctuelles des tangentes psi mesurées en fonction de la longueur d'onde, avec un ellipsomètre en ligne droite et une fenêtre inclinée à 58°. Ces points mesurés sont à comparer à la courbe C1 qui exprime le calcul du paramètre tangente psi selon les équations mentionnés ci-avant, avec une fenêtre en PUROPSIL.

Il convient d'observer que le facteur de correction exprimé dans l'équation 21 doit être appliqué deux fois en raison de la double traversée de la fenêtre (en illumination et en réflexion).

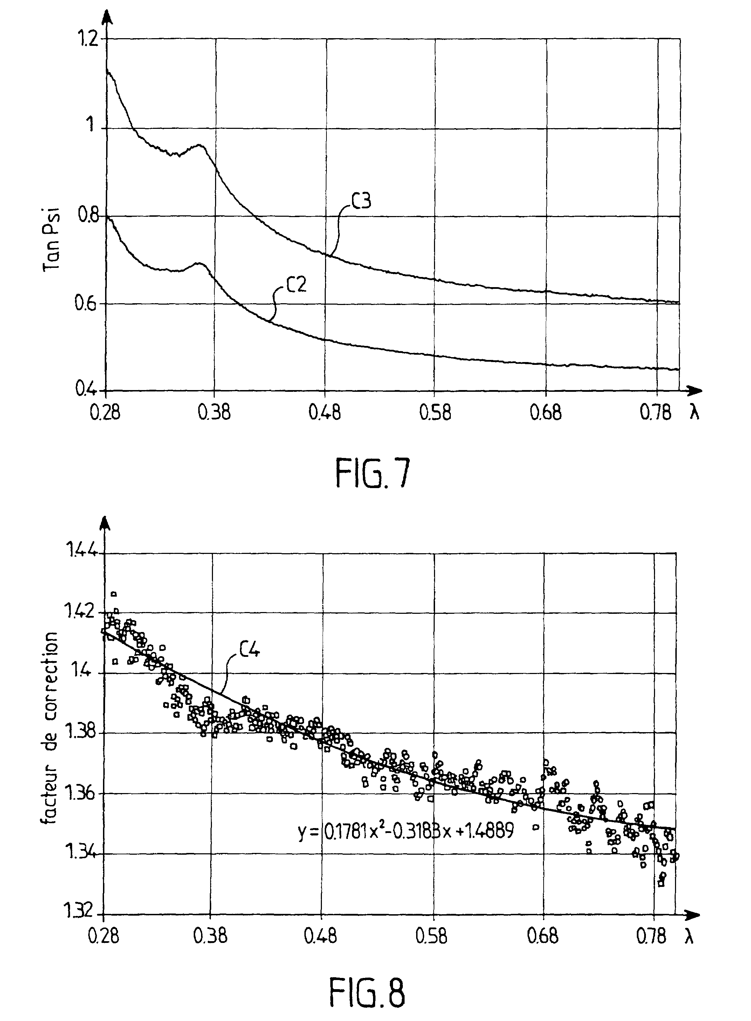

En théorie, la calibration de l'effet de la fenêtre peut être réalisée en ligne droite avec une fenêtre inclinée à une incidence par exemple de 58°. Mais en pratique, il convient d'évaluer le facteur de correction sur le paramètre tangente $\Psi$ en utilisant le ratio ( courbe C4 en figure 8) de deux mesures de tangente psi (figure 7), l'une (courbe C2) mesuré sans fenêtre et l'autre (courbe C3) mesuré avec fenêtre (figure 7), sur un échantillon en position de mesure et après réglage des éléments optiques.

En pratique, l'étape de calibration comprend les étapes suivantes :

1) - effectuer au moins une première mesure ellipsométrique sur un échantillon prédéterminé, selon des premières conditions expérimentales, sans fenêtre;

2) - effectuer au moins une seconde mesure ellipsométrique sur le même échantillon que celui de l'étape 1), selon des secondes conditions expérimentales généralement semblables aux premières conditions expérimentales, mais à travers la fenêtre;

3) - déterminer à partir des premières et secondes mesures ellipsométriques, l'effet résultant de la fenêtre sur le rapport des amplitudes tangente $\Psi$ des polarisations perpendiculaires et parallèles du faisceau de réflexion pour en déduire un facteur de correction; et

4) - tenir compte dans le traitement selon l'étape précédente, du facteur de correction ainsi déduit.

L'approximation polynomiale (figure 8) peut être utilisée directement pour corriger les mesures sur d'autres exemples.

Une cartographie peut être réalisée grâce à l'invention. La cartographie consiste à maintenir l'échantillon fixe dans la chambre, à déplacer longitudinalement et/ou latéralement le faisceau d'illumination polarisé pour illuminer une autre zone de l'échantillon, et à répéter les différentes étapes du procédé selon le même angle d'incidence oblique, ce qui permet d'effectuer une pluralité de mesures d'ellipsométrie sur une pluralité de zones de l'échantillon, sans déplacer ledit échantillon et sans sortir l'échantillon hors de la chambre.

Le procédé comprend en outre une étape qui consiste à déplacer transversalement le faisceau d'illumination sur l'échantillon fixe à travers la fenêtre afin d'ajuster la distance entre l'appareil de métrologie et la surface de l'échantillon.

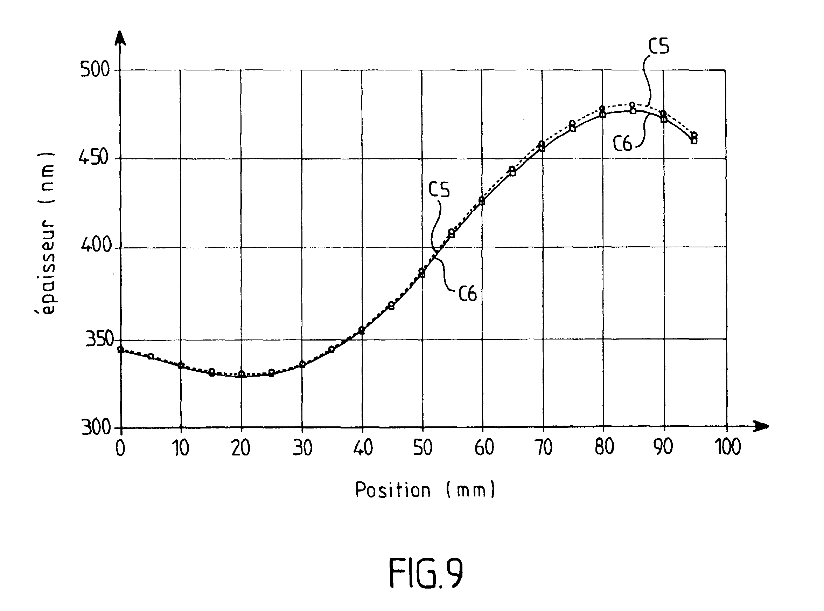

En référence à la figure 9, on a représenté des mesures d'épaisseur en nm d'un échantillon comportant une couche de silice sur un substrat de silicium ayant un rayon de 100 mm. La courbe C5 représente les mesures effectuées sans fenêtre tandis que la courbe C6 représente les mesures effectuées avec fenêtre (et corrigées selon le facteur de correction décrit ci-avant). Le bon accord entre les deux courbes montrent que la cartographie de l'échantillon à travers la fenêtre selon l'invention sur une course en X de 100 mm est totalement cohérente avec la même mesure effectuée sans fenêtre.

En variante, la fenêtre peut être divisée en des première et seconde fenêtres de dimensions et caractéristiques identiques et choisies pour permettre le passage respectif des faisceaux d'illumination et de réflexion.

La chambre est par exemple une chambre de refroidissement propre à s'adapter à une ligne de production de circuits intégrés, afin de recevoir des échantillons à mesurer issus d'une chambre d'élaboration de ladite ligne de production.

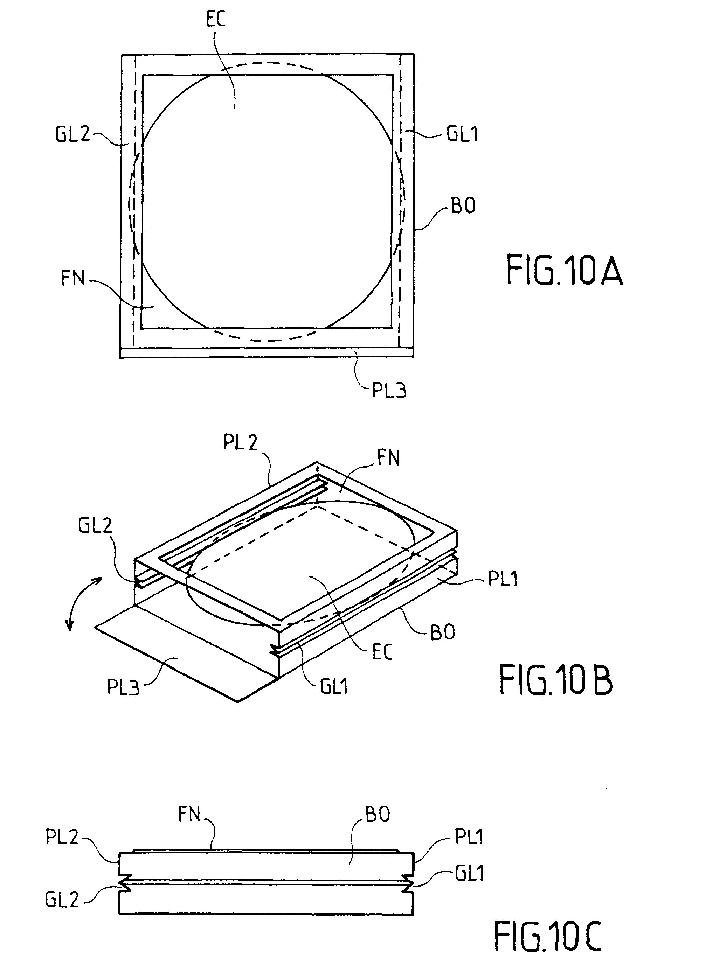

En variante (figures 10A à 10C), la chambre peut être une boîte BO formant porte-échantillon propre à contenir un échantillon EC et pouvant être chargée ou extraite en lieu et place de l'échantillon sur l'appareil de métrologie décrit ci-avant.

Par exemple, la boîte BO est de forme parallélépipédique. Elle possède deux parois longitudinales PL1 et PL2 équipées chacune d'une glissière GL1, GL2 pour maintenir l'échantillon EC à l'intérieur de la boîte BO. La boîte comprend en outre une paroi latérale PL3 rabattable permettant le chargement-/déchargement de l'échantillon dans/ de la boîte. Selon l'invention, la boîte comprend une face supérieure équipée d'une fenêtre FN fermant la boîte.

Il est à remarquer que la fenêtre selon l'invention peut aussi jouer le rôle d'isolation thermique, notamment dans le cas de mesures ellipsométriques menées en environnement thermique contrôlé (four, cryostat).

## ANNEXE

$$\begin{bmatrix} a & 0 \\ 0 & b \end{bmatrix} * \begin{bmatrix} r_p & 0 \\ 0 & r_s \end{bmatrix} * \begin{bmatrix} a & 0 \\ 0 & b \end{bmatrix} \qquad\qquad \text{Equation 9}$$

$$\tan\psi^{avec} = \left[\left|\frac{a}{b}\right|\right]^2 * \tan\psi^{sans} \qquad\qquad \text{Equation 10}$$

$$\cos\Delta^{avec} = \cos(\Delta^{sans} - 2(\delta_a - \delta_b)) \qquad\qquad \text{Equation 11}$$

$$T = \frac{t_{01}t_{10}e^{-j\beta}}{1+r_{01}r_{10}e^{-2j\beta}} = t_{01}t_{10}e^{-j\delta} \qquad\qquad \text{Equation 12}$$

$$t_{01}{}^p = \frac{2\cos\varphi_0}{n\cos\varphi_0 + \cos\varphi_1} \qquad\qquad \text{Equation 13}$$

$$t_{01}{}^s = \frac{2\cos\varphi_0}{\cos\varphi_0 + n\cos\varphi_1} \qquad\qquad \text{Equation 14}$$

$$r_{01}{}^p = \frac{n\cos\varphi_0 - \cos\varphi_1}{n\cos\varphi_0 + \cos\varphi_1} \qquad \text{Equation 15}$$

$$r_{01}{}^s = \frac{\cos\varphi_0 - n\cos\varphi_1}{\cos\varphi_0 + n\cos\varphi_1} \qquad \text{Equation 16}$$

$$\beta = 2\pi \left[\frac{d}{\lambda}\right] \sqrt{n^2 - \sin^2\varphi_0} \qquad \text{Equation 17}$$

**ANNEXE**

$$t_{01}{}^*t_{10} = 1 - r_{01}{}^2 \qquad \text{Equation 18}$$

$$a = (1 - r_{01p}{}^2)e^{-j\beta} \qquad \text{Equation 19}$$

$$b = (1 - r_{01s}{}^2)e^{-j\beta} \qquad \text{Equation 20}$$

$$\left[\left|\frac{a}{b}\right|\right]^2 = \left[\frac{1 - r_{01p}{}^2}{1 - r_{01s}{}^2}\right]^2 \qquad \text{Equation 21}$$

$$\delta_a - \delta_b = 0 \qquad \text{Equation 22}$$

**Revendications**

1. Procédé de métrologie ellipsométrique, du type comprenant les étapes suivantes:

    i) illuminer (4) un échantillon (EC) par une source de lumière (2), à travers un polariseur (10) et une fenêtre (22) de dimensions et caractéristiques choisies, cette illumination s'effectuant selon un premier chemin optique qui atteint une zone de l'échantillon sous un angle d'incidence oblique prédéterminé (AI), la fenêtre étant placée dans la paroi d'une chambre enfermant l'échantillon,

    ii) recueillir le faisceau de réflexion (26) symétrique du faisceau d'illumination par rapport à la normale à la surface de l'échantillon, selon un second chemin optique allant de l'échantillon vers un dispositif analyseur de polarisation (24) à travers la fenêtre (22);

    iii) détecter le faisceau de sortie issu du dispositif analyseur (24) pour fournir un signal de sortie; et

    iv) traiter le signal de sortie pour déterminer les changements de l'état de polarisation causés par la réflexion sur la zone de l'échantillon ;

    **caractérisé en ce qu'**à l'étape i), la fenêtre est à faces parallèles, et placée parallèlement à la surface de l'échantillon (EC),

    à l'étape iv), le traitement comprend l'application d'un facteur de correction déterminé à l'avance à partir de l'effet de la fenêtre sur le rapport d'amplitude tangente $\Psi$ (PSI) entre les polarisations perpendiculaire et parallèle du faisceau réfléchi,

et **en ce que** le procédé comprend en outre l'étape suivante:

v) répéter les étapes i) à iv) en déplaçant longitudinalement et/ou latéralement le faisceaù d'illumination polarisé pour illuminer à chaque fois une autre zone de l'échantillon à travers la fenêtre.

2. Procédé selon la revendication 1, **caractérisé en ce que** l'étape v) comprend en outre un déplacement du faisceau d'illumination, à travers la fenêtre, afin d'ajuster la distance entre l'appareil de métrologie et la surface de l'échantillon.

3. Procédé selon l'une des revendications 1 et 2, **caractérisé en ce qu'**il comprend en outre une étape de calibration comprenant les sous-étapes suivantes:

1) effectuer au moins une première mesure ellipsométrique sur un échantillon prédéterminé, selon de premières conditions expérimentales, sans fenêtre,
2) effectuer au moins une seconde mesure ellipsométrique sur le même échantillon que celui de l'étape 1), selon de secondes conditions expérimentales généralement semblables aux premières conditions expérimentales, mais à travers la fenêtre (22),
3) déterminer à partir des première et seconde mesures ellipsométriques, l'effet résultant de la fenêtre sur le rapport des amplitudes tangente $\Psi$ des polarisations perpendiculaires et parallèles du faisceau de réflexion pour en déduire le facteur de correction.

4. Procédé selon l'une des revendications précédentes, **caractérisé en ce qu'**il comprend en outre une étape d'observation de l'échantillon à travers la fenêtre.

5. Procédé selon la revendication 4, **caractérisé en ce que** l'étape d'observation comprend une prise de vue par caméra (48), sensiblement sous incidence normale à travers la fenêtre.

6. Procédé selon l'une des revendications 4 et 5, **caractérisé en ce qu'**il comprend en outre une étape d'observation du faisceau à des fins d'autofocus.

7. Procédé selon l'une des revendications précédentes, **caractérisé en ce que** la fenêtre forme isolation entre le montage ellipsométrique et l'échantillon.

8. Procédé selon l'une des revendications précédentes, **caractérisé en ce que** la source de lumière est polychromatique.

9. Appareil de métrologie ellipsométrique, du type comprenant:

- une source de lumière (2) pour produire un faisceau d'illumination (4), appliqué à travers un polariseur (10) à une fenêtre (22) de dimensions et caractéristiques choisies, la fenêtre étant placée dans la paroi d'une chambre enfermant l'échantillon,
- un premier dispositif optique (20) pour acheminer le faisceau d'illumination (4) selon un premier chemin optique allant du dispositif polariseur à travers une fenêtre (22) jusqu'à une zone de l'échantillon, qu'il atteint selon un angle d'incidence oblique prédéterminé (AI);
- un second dispositif optique (28) pour acheminer le faisceau de réflexion (26), symétrique du faisceau d'illumination par rapport à la normale à la surface de l'échantillon selon un second chemin optique allant de l'échantillon vers un dispositif analyseur de polarisation (24) à travers la fenêtre (22);
- un dispositif de détection (30) pour détecter le faisceau de sortie issu du dispositif analyseur (24) pour fournir un signal de sortie ; et
- des moyens de traitement (40) pour traiter le signal de sortie pour déterminer les changements de l'état de polarisation causés par la réflexion sur la zone de l'échantillon,

**caractérisé en ce que** la fenêtre à faces parallèles et est placée parallèlement à la surface de l'échantillon; les moyens de traitement sont agencés pour appliquer un facteur de correction déterminé à l'avance à partir de l'effet de la fenêtre sur le rapport d'amplitude tangente $\psi$, (PSI) entre les polarisations perpendiculaire et parallèle du faisceau réfléchi,
**en ce que** l'appareil comprend en outre des moyens de déplacement (46) pour déplacer longitudinalement et/ou latéralement le faisceau d'illumination polarisé pour illuminer à chaque fois une autre zone de l'échantillon, selon le même angle d'incidence oblique à travers la fenêtre.

10. Appareil selon la revendication 9, **caractérisé en ce que** les moyens de déplacement (46) sont propres à déplacer le faisceau d'illumination sur l'échantillon fixe, ce qui permet d'ajuster la distance entre l'appareil de métrologie et la surface de l'échantillon.

11. Appareil selon l'une des revendications 9 et 10, **caractérisé en ce que** les moyens de déplacement (46) comprennent une table ajustable en X, et/ou en Y, et/ou en Z.

12. Appareil selon la revendication 11, **caractérisé en ce que** la table (46) est apte à porter le dispositif polariseur (10), le dispositif analyseur (24), et les premier et second dispositifs d'acheminement 20 et 28).

13. Appareil selon l'une des revendications 9 à 12, **caractérisé en ce qu'**il comprend une première fibre optique (12) disposée entre la source lumineuse (2) et le dispositif polariseur (10).

14. Appareil selon l'une des revendications 9 à 13, **caractérisé en ce qu'**il comprend une seconde fibre optique (34) disposée entre le dispositif analyseur (24) et le dispositif de détection (30).

15. Appareil selon l'une des revendications 9 à 14, **caractérisé en ce qu'**il comprend un diaphragme (14) disposé en amont du dispositif polariseur (10) selon le sens de la propagation de la lumière.

16. Appareil selon l'une des revendications 9 à 15, **caractérisé en ce qu'**il comprend une lame compensatrice (21) interposée entre le polariseur (10) et la fenêtre (22).

17. Appareil selon l'une des revendications 9 à 16, **caractérisé en ce qu'**il comprend une lame compensatrice (27) interposée entre la fenêtre (22) et l'analyseur (24).

18. Appareil selon l'une des revendications 9 à 17, **caractérisé en ce qu'**il comprend une couche d'un matériau de compensation revêtant la surface interne et/ou externe de la fenêtre (22).

19. Appareil selon l'une des revendications 9 à 18, **caractérisé en ce qu'**il comprend en outre au moins un organe d'observation de l'échantillon à travers la fenêtre.

20. Appareil selon la revendication 19, **caractérisé en ce que** l'organe d'observation comprend une caméra de prise de vues (48), sensiblement sous incidence normale à travers la fenêtre.

21. Appareil selon l'une des revendications 19 et 20, **caractérisé en ce qu'**il comprend en outre un organe d'observation du faisceau à des fins d'autofocus.

22. Appareil selon l'une des revendications 9 à 21, **caractérisé en ce que** la fenêtre, forme isolation entre le montage ellipsométrique et l'échantillon.

23. Appareil selon la revendication 22, **caractérisé en ce que** la chambre (CH3) est une chambre de refroidissement propre à s'adapter à une ligne de production de circuits intégrés, afin de recevoir des échantillons à mesurer issus de ladite ligne de production.

24. Appareil selon la revendication 22, **caractérisé en ce que** la chambre est une boîte formant porte-échantillon propre à contenir un échantillon et comprenant une interface conjuguée avec l'appareil de métrologie.

25. Appareil selon l'une des revendications 9 à 24, **caractérisé en ce que** la source de lumière est polychromatique.

26. Appareil selon l'une des revendications 9 à 25, **caractérisé en ce que** la fenêtre (22) comprend des première et seconde fenêtres, de dimensions et caractéristiques identiques, et choisies pour permettre le passage respectif des faisceaux d'illumination et de réflexion.

**Claims**

1.  Ellipsometric metrology method of the type comprising the following steps:

    i) illuminate (4) a sample (EC) with a light source (2), through a polariser (10) and a window (22) of selected dimensions and characteristics, this illumination being effected along a first optical path which hits a region of the sample at a predetermined oblique angle of incidence (AI), the window being located in the wall of a chamber enclosing the sample,

    ii) collect the reflected beam (26) symmetrical with the illuminating beam relative to the normal to the sample surface along a second optical path extending from the sample through the window (22) towards a polarisation analysis device (24);

    iii) detect the output beam transmitted from the analysis device (24) in order to supply an output signal; and

    iv) process the output signal in order to determine the changes in state of polarisation caused by reflection on the region of the sample;

    **characterised in that** in step i), the window has parallel faces and is located parallel to the sample surface (EC), in step

    iv) processing comprises the application of a correction factor determined in advance from the effect of the window on the ratio of amplitude of tangent $\Psi$ (PSI) between the perpendicular and parallel polarisations of the reflected beam, and **in that** the method further comprises the following step:

    v) repeat steps i) to iv), displacing the polarised illuminating beam longitudinally and/or laterally in order to illuminate a different region of the sample through the window each time.

2.  Method according to claim 1, **characterised in that** step v) further comprises displacement of the illuminating beam through the window in order to adjust the distance between the metrology apparatus and the surface of the sample.

3.  Method according to either of claims 1 or 2, **characterised in that** it further comprises a calibration step **comprising** in the following sub-steps:

    1) effect at least one first ellipsometric measurement on a predetermined sample, according to first experimental conditions, without a window,

    2) effect at least one second ellipsometric measurement on the same sample as that of step 1), according to second experimental conditions generally similar to the first, but through the window (22),

    3) determine from the first and second ellipsometric measurements the effect **resulting from** of the window on the ratio of amplitudes of tangent $\Psi$ of the perpendicular and parallel polarisations of the reflected beam in order to deduce the correction factor therefrom.

4.  Method according to one of the preceding claims, **characterised in that** it further comprises a step of observation of the sample through the window.

5.  Method according to claim 4, **characterised in that** the observation step comprises a shot by camera (48), substantially with normal incidence through the window.

6.  Method according to either of claims 4 or 5, **characterised in that** it further comprises a step of observation of the beam for auto-focusing purposes.

7.  Method according to one of the preceding claims, **characterised in that** the window forms an insulation between the ellipsometric assembly and the sample.

8.  Method according to one of the preceding claims, **characterised in that** the light source is polychrome.

9.  Ellipsometric metrology apparatus of the type comprising:

    -   a light source (2) for producing an illuminating beam (4), applied through a polariser (10) to a window (22) of selected dimensions and characteristics, the window being located in the wall of a chamber enclosing the sample,

- a first optical device (20) for guiding the illuminating beam (4) along a first optical path extending from the polarising device through a window (22) to a region of the sample, which it hits at a predetermined oblique angle of incidence (Al);
- a second optical device (28) for guiding the reflected beam (26) symmetrical to the illuminating beam relative to the normal to the surface of the sample along a second optical path extending from the sample through the window (22) to a polarisation analysis device (24);
- a detection device (30) for detecting the output beam emitted from the analysis device (24) in order to supply an output signal; and
- processing means (40) for processing the output signal in order to determine the changes in state of polarisation caused by the reflection on a region of the sample,

**characterised in that** the window with parallel faces is located parallel to the surface of the sample;
the processing means are arranged to apply a correction factor determined in advance from the effect of the window on the ratio of amplitude of tangent Ψ (PSI) between the perpendicular and parallel polarisations of the reflected beam,
and **in that** the apparatus further comprises means of displacement (46) for displacing the polarised illuminating beam longitudinally and/or laterally in order to illuminate a different region of the sample each time, at the same oblique angle of incidence through the window.

10. Apparatus according to claim 9, **characterised in that** the displacement means (46) are capable of displacing the illuminating beam on the fixed sample, which makes it possible to adjust the distance between the metrology apparatus and the surface of the sample.

11. Apparatus according to either of claims 9 or 10, **characterised in that** the displacement means (46) comprise a table adjustable in the X and/or Y and/or Z directions.

12. Apparatus according to claim 11, **characterised in that** the table (46) is adapted to carry the polarising device (10), the analysis device (24), and the first and second guiding devices (20) and (28).

13. Apparatus according to one of claims 9 to 12, **characterised in that** it comprises a first optical fibre (12) disposed between the light source (2) and the polarising device (10).

14. Apparatus according to one of claims 9 to 13, **characterised in that** it comprises a second optical fibre (34) disposed between the analysis device (24) and the detection device (30).

15. Apparatus according to one of claims 9 to 14, **characterised in that** it comprises a diaphragm (14) disposed upstream of the polarising device (10) in the direction of propagation of light.

16. Apparatus according to one of claims 9 to 15, **characterised in that** it comprises a compensating slide (21) interposed between the polariser (10) and the window (22).

17. Apparatus according to one of claims 9 to 16, **characterised in that** it comprises a compensating slide (27) interposed between the window (22) and the analyser (24).

18. Apparatus according to one of claims 9 to 17, **characterised in that** it comprises a layer of a compensating material covering the internal and/or external surface of the window (22).

19. Apparatus according to one of claims 9 to 18, **characterised in that** it further comprises at least one element for observing the sample through the window.

20. Apparatus according to claim 19, **characterised in that** the observation element comprises a camera for taking shots (48) substantially with normal incidence through the window.

21. Apparatus according to either of claims 19 or 20, **characterised in that** it further comprises an element for observing the beam for auto-focusing purposes.

22. Apparatus according to one of claims 9 to 21, **characterised in that** the window forms an insulation between the ellipsometric assembly and the sample.

**23.** Apparatus according to claim 22, **characterised in that** the chamber (CH3) is a cooling chamber capable of adapting to a production line for integrated circuits, in order to receive samples to be measured coming off the production line.

**24.** Apparatus according to claim 22, **characterised in that** the chamber is a box forming a sample-carrier fit to contain one sample and comprising an interface linked to the metrology apparatus.

**25.** Apparatus according to one of claims 9 to 24, **characterised in that** the light source is polychrome.

**26.** Apparatus according to one of claims 9 to 25, **characterised in that** the window (22) comprises first and second windows of identical dimensions and characteristics selected to permit the passage of the illuminating beam and reflected beam respectively.

**Patentansprüche**

**1.** Ellipsometrisches Messverfahren von der Art, welches die folgenden Schritte umfasst:

i) Beleuchten einer Probe (EC) mit einer Lichtquelle (2) durch einen Polarisator (10) und ein Fenster (22) mit ausgewählten Abmessungen und Eigenschaften, wobei die Beleuchtung entlang eines ersten optischen Pfads stattfindet, der einen Bereich der Probe unter einem vorbestimmten, schrägen Einfallwinkel (AI) erreicht, wobei das Fenster in der Wand einer Kammer angeordnet ist, welche die Probe einschließt,
ii) Auffangen des reflektierten Strahls (26), der zum Beleuchtungsstrahl bezüglich einer Senkrechten der Oberfläche der Probe symmetrisch ist, entlang eines zweiten optischen Pfads, der durch das Fenster (22) hindurch von der Probe zu einer Polarisierungsanalysatorvorrichtung (24) verläuft;
iii) Erfassen des aus der Analysatorvorrichtung (24) austretenden Ausgangsstrahls, um ein Ausgangssignal bereitzustellen; und
iv) Verarbeiten des Ausgangssignals, um die Änderungen des Polarisierungszustands zu bestimmen, die durch die Reflexion im Bereich der Probe hervorgerufen wurden;

**dadurch gekennzeichnet, dass**

- im Schritt i) das Fenster parallele Flächen aufweist und parallel zur Oberfläche der Probe (EC) angeordnet ist,
- im Schritt iv) die Verarbeitung die Anwendung eines Korrekturfaktors umfasst, der zuvor aus der Auswirkung des Fensters auf das Verhältnis Amplitude-Tangente $\psi$ (PSI) zwischen der senkrechten und der parallelen Polarisierung des reflektierten Strahls bestimmt wurde, und
das Verfahren darüber hinaus noch den folgenden Schritt umfasst:

v) Wiederholen der Schritte i) bis iv), wobei der polarisierte Beleuchtungsstrahl längs und/oder seitlich verschoben wird, um dabei jeweils einen anderen Bereich der Probe durch das Fenster hindurch zu beleuchten.

**2.** Verfahren nach Anspruch 1,
**dadurch gekennzeichnet, dass**
der Schritt v) darüber hinaus eine Verschiebung des Beleuchtungsstrahls durch das Fenster umfasst, um den Abstand zwischen dem Messgerät und der Oberfläche der Probe einzustellen.

**3.** Verfahren nach einem der Ansprüche 1 und 2,
**dadurch gekennzeichnet, dass**
es darüber hinaus einen Kalibrierungsschritt umfasst, der die folgenden Teilschritte umfasst:

1) Durchführen mindestens einer ersten ellipsometrischen Messung an einer vorbestimmten Probe gemäß ersten Versuchsbedingungen ohne Fenster,
2) Durchführen mindestens einer zweiten ellipsometrischen Messung an derselben Probe wie derjenigen von Schritt 1) gemäß zweiten, den ersten Versuchsbedingungen im Wesentlichen ähnlichen Versuchsbedingungen, aber durch das Fenster (22) hindurch,
3) Bestimmen der vom Fenster ausgehenden Auswirkungen auf das Verhältnis der Amplituden-Tangente $\psi$ der senkrechten und parallelen Polarisierungen des reflektierten Strahls aus den ersten und zweiten ellipsometrischen Messungen, um daraus den Korrekturfaktor abzuleiten.

**4.** Verfahren nach einem der vorhergehenden Ansprüche,
**dadurch gekennzeichnet, dass**
es darüber hinaus noch einen Schritt umfasst, die Probe durch das Fenster hindurch zu beobachten.

**5.** Verfahren nach Anspruch 4,
**dadurch gekennzeichnet, dass**
der Beobachtungsschritt eine Kamerabildaufnahme (48) durch das Fenster hindurch im Wesentlichen unter senkrechtem Einfallwinkel umfasst.

**6.** Verfahren nach einem der Ansprüche 4 und 5,
**dadurch gekennzeichnet, dass**
es darüber hinaus noch einen Beobachtungsschritt des Strahls zu Autofokuszwecken umfasst.

**7.** Verfahren nach einem der vorhergehenden Ansprüche,
**dadurch gekennzeichnet, dass**
das Fenster eine Isolierung zwischen dem ellipsometrischen Aufbau und der Probe bildet.

**8.** Verfahren nach einem der vorhergehenden Ansprüche,
**dadurch gekennzeichnet, dass**
die Lichtquelle polychromatisch ist.

**9.** Ellipsometrisches Messgerät von der Art, die Folgendes umfasst:

- eine Lichtquelle (2) zum Erzeugen eines Beleuchtungsstrahls (4), der durch einen Polarisator (10) hindurch auf ein Fenster (22) mit ausgewählten Abmessungen und Eigenschaften angewendet wird, wobei das Fenster in der Wand einer Kammer angeordnet ist, welche die Probe einschließt,
- eine erste optische Einrichtung (20) zum Leiten des Beleuchtungsstrahls (4) entlang eines ersten optischen Pfads, der von der Polarisatoreinrichtung durch ein Fenster (22) hindurch bis zu einem Bereich der Probe verläuft, den er entlang eines vorbestimmten, schrägen Einfallwinkels (AI) erreicht;
- eine zweite optische Einrichtung (28) zum Leiten des reflektierten Strahls (26), der zum Beleuchtungsstrahl bezüglich der Senkrechten der Oberfläche der Probe symmetrisch ist, entlang eines zweiten optischen Pfads, der von der Probe durch das Fenster (22) hindurch zu einer Polarisierungsanalysatorvorrichtung (24) verläuft;
- eine Erfassungseinrichtung (30) zum Erfassen des aus der Analysatorvorrichtung (24) austretenden Ausgangsstrahls, um ein Ausgangssignal bereitzustellen; und
- Verarbeitungsmittel (40) zum Verarbeiten des Ausgangssignals, um Änderungen des Polarisierungszustands zu bestimmen, die durch die Reflexion im Bereich der Probe hervorgerufen wurden;

**dadurch gekennzeichnet, dass**
das mit parallelen Flächen versehene Fenster parallel zur Oberfläche der Probe angeordnet ist;

- die Verarbeitungsmittel so eingerichtet sind, dass sie einen Korrekturfaktor anwenden, der zuvor aus der Auswirkung des Fensters auf das Verhältnis der Amplitude-Tangente $\psi$ (PSI) zwischen der senkrechten und der parallelen Polarisierung des reflektierten Strahls bestimmt wurde,
- das Gerät darüber hinaus noch Verschiebungsmittel (46) umfasst, um den polarisierten Beleuchtungsstrahl längs und/oder seitlich zu verschieben, um jeweils einen anderen Bereich der Probe durch das Fenster hindurch unter demselben schrägen Einfallwinkel zu beleuchten.

**10.** Gerät nach Anspruch 9,
**dadurch gekennzeichnet, dass**
die Verschiebungsmittel (46) geeignet sind, den Beleuchtungsstrahl über der feststehenden Probe zu verschieben, wodurch der Abstand zwischen dem Messgerät und der Oberfläche der Probe eingestellt werden kann.

**11.** Gerät nach einem der Ansprüche 9 und 10,
**dadurch gekennzeichnet, dass**
die Verschiebungsmittel (46) eine in X- und/oder Y- und/oder Z-Richtung einstellbare Platte umfassen.

**12.** Gerät nach Anspruch 11,
**dadurch gekennzeichnet, dass**

die Platte (46) geeignet ist, die Polarisierungsvorrichtung (10), die Analysatorvorrichtung (24) und die erste und die zweite Leitvorrichtung (20 und 28) zu haltern.

13. Gerät nach einem der Ansprüche 9 bis 12,
**dadurch gekennzeichnet, dass**
es einen ersten Lichtwellenleiter (12) umfasst, der zwischen der Lichtquelle (2) und der Polarisatorvorrichtung (10) angeordnet ist.

14. Gerät nach einem der Ansprüche 9 bis 13,
**dadurch gekennzeichnet, dass**
es einen zweiten Lichtwellenleiter (34) umfasst, der zwischen der Analysatorvorrichtung (24) und der Erfassungseinrichtung (30) angeordnet ist.

15. Gerät nach einem der Ansprüche 9 bis 14,
**dadurch gekennzeichnet, dass**
es eine Membran (14) umfasst, die in der Richtung der Fortpflanzung des Lichts vor der Polarisatorvorrichtung (10) angeordnet ist.

16. Gerät nach einem der Ansprüche 9 bis 15,
**dadurch gekennzeichnet, dass**
es eine Ausgleichsplatte (21) umfasst, die zwischen dem Polarisator (10) und dem Fenster (22) untergebracht ist.

17. Gerät nach einem der Ansprüche 9 bis 16,
**dadurch gekennzeichnet, dass**
es eine Ausgleichsplatte (27) umfasst, die zwischen dem Fenster (22) und der Analysatorvorrichtung (24) untergebracht ist.

18. Gerät nach einem der Ansprüche 9 bis 17,
**dadurch gekennzeichnet, dass**
es eine Schicht eines Ausgleichsmaterials umfasst, das die Innenund/oder Außenoberfläche des Fensters (22) bedeckt.

19. Gerät nach einem der Ansprüche 9 bis 18,
**dadurch gekennzeichnet, dass**
es darüber hinaus noch mindestens eine Einrichtung zum Beobachten der Probe durch das Fenster hindurch umfasst.

20. Gerät nach Anspruch 19,
**dadurch gekennzeichnet, dass**
die Beobachtungseinrichtung eine Kamera (48) zur Bildaufnahme durch das Fenster hindurch im wesentlichen unter senkrechtem Einfallwinkel umfasst.

21. Gerät nach einem der Ansprüche 19 und 20,
**dadurch gekennzeichnet, dass**
es darüber hinaus noch eine Beobachtungseinrichtung für den Strahl zu Autofokuszwecken umfasst.

22. Gerät nach einem der Ansprüche 19 bis 21,
**dadurch gekennzeichnet, dass**
das Fenster eine Isolierung zwischen dem ellipsometrischen Aufbau und der Probe bildet.

23. Gerät nach Anspruch 22,
**dadurch gekennzeichnet, dass**
die Kammer (CH3) eine Kühlkammer ist, die dazu ausgelegt ist, einer Fertigungsstraße für integrierte Schaltungen angepasst zu werden, um aus der Fertigungsstraße austretende, zu messende Proben aufzunehmen.

24. Gerät nach Anspruch 22,
**dadurch gekennzeichnet, dass**
die Kammer ein Gehäuse ist, das einen Probenhalter bildet, der dazu ausgelegt ist, eine Probe zu enthalten, und das eine Schnittstelle umfasst, die dem Messgerät zugeordnet ist.

25. Gerät nach einem der Ansprüche 19 bis 24,
**dadurch gekennzeichnet, dass**
die Lichtquelle polychromatisch ist.

26. Gerät nach einem der Ansprüche 19 bis 25,
**dadurch gekennzeichnet, dass**
das Fenster (22) erste und zweite Fenster mit gleichen Abmessungen und Eigenschaften umfasst, die so ausgewählt sind, dass sie den Durchgang der Beleuchtungsstrahlen bzw. der reflektierten Strahlen zulassen.

FIG.1

FIG.2

FIG.3

EL

EP 1 158 291 B1

EP 1 158 291 B1

FIG.4

FIG.5

20

FIG.6

FIG.7

$$y = 0.1781x^2 - 0.3183x + 1.4889$$

FIG.8

FIG.9

EP 1 158 291 B1

EC

GL2

GL1

BO

FN

PL3

FIG.10 A

PL2

FN

GL2

PL1

PL3

BO

EC

GL1

FIG.10 B

FN

BO

PL2

PL1

GL2

GL1

FIG.10 C